(19) Europäisches Patentamt
European Patent Office
Office européen des brevets

(11) **EP 4 401 272 B1**

(12) **EUROPEAN PATENT SPECIFICATION**

(45) Date of publication and mention
of the grant of the patent:
**04.03.2026  Bulletin 2026/10**

(21) Application number: **22887367.5**

(22) Date of filing: **23.09.2022**

(51) International Patent Classification (IPC):
*H02J 7/00* (2026.01)     *H02J 7/34* (2006.01)
*H01M 10/42* (2006.01)

(52) Cooperative Patent Classification (CPC):
**H01M 10/42; H01M 10/48; H02J 7/345; H02J 7/62;**
**H02J 7/663; H02J 7/80;** H01M 2010/4271;
H02J 2207/50; Y02E 60/10

(86) International application number:
**PCT/KR2022/014257**

(87) International publication number:
**WO 2023/075163 (04.05.2023 Gazette 2023/18)**

(54) **BATTERY DEVICE, BATTERY SYSTEM AND DIAGNOSIS METHOD**

BATTERIEVORRICHTUNG, BATTERIESYSTEM UND DIAGNOSEVERFAHREN

DISPOSITIF DE BATTERIE, SYSTÈME DE BATTERIE ET PROCÉDÉ DE DIAGNOSTIC

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority:  **01.11.2021  KR 20210147895**

(43) Date of publication of application:
**17.07.2024  Bulletin 2024/29**

(73) Proprietor: **LG Energy Solution, Ltd.**
**Seoul 07335 (KR)**

(72) Inventor: **LEE, Hojoon**
**Daejeon 34122 (KR)**

(74) Representative: **Plasseraud IP**
**104 Rue de Richelieu**
**CS92104**
**75080 Paris Cedex 02 (FR)**

(56) References cited:
JP-B2- 6 445 989      KR-B1- 100 867 834
KR-B1- 100 867 834    KR-B1- 101 047 635
KR-B1- 102 134 825    KR-B1- 102 134 825
US-A1- 2015 219 720   US-A1- 2020 144 832

## Description

**[Technical Field]**

The disclosure relates to a battery device, a battery management system, and a diagnosis method.

**[Background Art]**

Electric vehicles and hybrid vehicles are vehicles obtaining power by mainly using batteries as power sources for driving motors, and are alternatives capable of solving pollution and energy problems of internal combustion vehicles. For this reason, research has been actively carried out on them. Further, rechargeable batteries have been used in vehicles and even in various other external apparatuses.

Recently, as high-power high-capacity batteries have been required, battery packs including a plurality of battery cells connected in series or parallel have been used. Furthermore, the potential risk of battery packs has increased as their power and capacity have increased. Particularly, when an overcurrent flows in a battery pack, if the overcurrent is not diagnosed, due to the overcurrent, problems may occur in external devices.

In order to prevent rush current of such overcurrent which is generated in the initial stage of driving, precharge circuits have been used. Precharge circuits can prevent rush current by first charging capacitors connected to inverters and so on of external devices through precharge resistors in the initial stage of driving. By the way, if the time that it takes to precharge a capacitor is not sufficient, a main switch may be closed in the state where the capacitor has not been charged to a sufficient voltage. In this case, the main switch may be damaged due to the difference between the voltage of the battery pack and the voltage of the capacitor. The document US 2020/0144832 is known, but fails to solve the aforementioned issue.

**[Disclosure]**

The present invention has been made in an effort to provide a battery device, a battery management system, and a diagnosis method having advantages of being capable of diagnosing a precharge operation.

An embodiment of the present invention provides a battery device as defined by the independent claim 1. In detail, the device comprises a positive connection terminal and a negative connection terminal which are connected to an external device. The battery device may include a battery pack, a positive main switch, a precharge switch, and a processor. The positive main switch may be connected between the positive terminal of the battery pack and the positive connection terminal. The precharge switch may be connected between the positive terminal of the battery pack and the positive precharge switch during a precharge duration, and close the positive main switch after the precharge duration, and diagnose the precharge operation on the basis of a first voltage of the positive connection terminal immediately before closing the positive main switch and a second voltage of the positive connection terminal immediately after closing the positive main switch.

In some embodiments, the battery device may further include a precharge resistor that is connected between the positive terminal and the positive connection terminal when the precharge switch is closed.

In some embodiments, the precharge switch and the precharge resistor may be connected in series.

In some embodiments, the processor may calculate the ratio of the second voltage to the first voltage, and diagnose the precharge operation by comparing the ratio of the second voltage to the first voltage with a criterion ratio.

In some embodiments, the precharge duration may be set to a multiple of a time constant defined by the resistance value of the precharge resistor and the capacitance of the capacitor, and the criterion ratio may be a ratio defined by the multiple of the time constant.

In some embodiments, when the ratio of the second voltage to the first voltage is included in an error range of the criterion ratio, the processor may diagnose that the precharge operation is normal.

In some embodiments, the precharge duration may be set to 1 times the time constant defined by the resistance value of the precharge resistor and the capacitance of the capacitor. **The** processor may calculate the ratio of the second voltage to the first voltage, and determine 2 times the time constant diagnose the precharge operation by comparing 1 times the time constant and 2 times the time constant.

In some embodiments, when 2 times the time constant is included in an error range of 1 times the time constant, the processor may diagnose that the precharge operation is normal.

In some embodiments, the processor may calculate the ratio of the second voltage to the first voltage, and determine a multiple of the time constant corresponding to the ratio of the second voltage to the first voltage, and estimate the capacitance of the capacitor on the basis of the multiple of the time constant, the precharge duration, and the resistance value of the precharge resistor, and diagnose the precharge operation by comparing the estimated capacitance and the actual capacitance of the capacitor.

In some embodiments, when the estimated capacitance is within an error range of the actual capacitance, the processor may diagnose that the precharge operation is normal.

Another embodiment of the present invention, as defined in the independent claim 11, provides a diagnosis method of a battery device including a battery pack, and a positive connection terminal and a negative connection terminal to be connected to an external device. The diagnosis method includes a step of performing a precharge operation of precharging a capacitor connected to the positive connection terminal and the negative connection terminal through a precharge resistor, a step of applying the voltage of the battery pack to the positive connection terminal after performing the precharge operation, a step of voltage of the positive connection terminal as a first voltage immediately before applying the voltage of the battery pack, a step of measuring the voltage of the positive connection terminal as a second voltage immediately after applying the voltage of the battery pack, and a step of diagnosing the precharge operation by comparing the first voltage with the second voltage.

In some embodiments, the step of diagnosing the precharge operation may include a step of calculating the ratio of the second voltage to the first voltage, and a step of diagnosing the precharge operation by comparing the ratio of the second voltage to the first voltage with a criterion ratio.

In some embodiments, the precharge duration may be set to 1 times the time constant defined by the resistance value of the precharge resistor and the capacitance of the capacitor. The step of diagnosing the precharge operation may include a step of calculating the ratio of the second voltage to the first voltage, a step of determining 2 times the time constant corresponding to the ratio of the second voltage to the first voltage, and a step of diagnosing the precharge operation by comparing 1 times the time constant and 2 times the time constant.

In some embodiments, the step of diagnosing the precharge operation may include a step of calculating the ratio of the second voltage to the first voltage, a step of determining a multiple of the time constant corresponding to the ratio of the second voltage to the first voltage, a step of estimating the capacitance of the capacitor on the basis of the multiple of the time constant, the precharge duration, and the resistance value of the precharge resistor, and a step of diagnosing the precharge operation by comparing the estimated step of diagnosing the precharge operation by comparing the estimated capacitance and the actual capacitance of the capacitor.

Yet another embodiment of the present invention provides a battery management system as defined in independent claim 15. The battery management system includes a positive main switch, a precharge switch, and a processor. The positive main switch may be connected between the positive terminal of the battery pack and the positive connection terminal. The precharge switch may be connected between the positive terminal of the battery pack and the positive connection terminal, and control a precharge operation of a capacitor of the external device. The processor may perform precharge by closing the precharge switch during a precharge duration, and close the positive main switch after the precharge duration, and diagnose the precharge operation on the basis of a first voltage of the positive connection terminal immediately before closing the positive main switch and a second voltage of the positive connection terminal immediately after closing the positive main switch

According to some embodiments, it is possible to diagnose a precharge operation by measuring the voltage of the positive connection terminal.

**[Description of the Drawings]**

FIG. 1 is a drawing illustrating an example of a battery device according to an embodiment.
FIG. 2 is a drawing illustrating an example of switching timings in the battery device according to the embodiment.
FIG. 3 is a flow chart illustrating an example of a diagnosis method of a battery device according to an embodiment.
FIG. 4 is a drawing illustrating an example of an equivalent circuit of a battery device according to an embodiment during a precharge duration.
FIG. 5 is a drawing illustrating an example of the voltage of a positive connection terminal in a battery device according to an embodiment.
FIG. 6 is a drawing illustrating voltage ratios depending on multiples of a time constant.

**[Mode for Invention]**

In the following detailed description, only certain embodiments of the present invention have been shown and described, simply by way of illustration. As those skilled in the art would realize, the described embodiments may be modified in various different ways, all without departing from the spirit or scope of the present invention. Accordingly, the drawings and description are to be regarded as illustrative in nature and not restrictive. Like reference numerals designate like elements throughout the specification.

It should be understood that when a constituent element is referred to as being "connected" to another constituent element, it may be directly connected to the other constituent element, or other constituent elements may be present between them. In contrast, it should be understood that when a constituent element is referred to as being "directly connected" to another constituent element, there is no other constituent element between them.

In the following description, expressions written in the singular forms can be comprehended as the singular forms or plural forms unless clear expressions such as "a", "an", or "single" are used.

In the flow charts described with reference to the drawings, the order of operations may be changed, and several operations may be combined, and an operation may be divided, and some operations may not be performed.

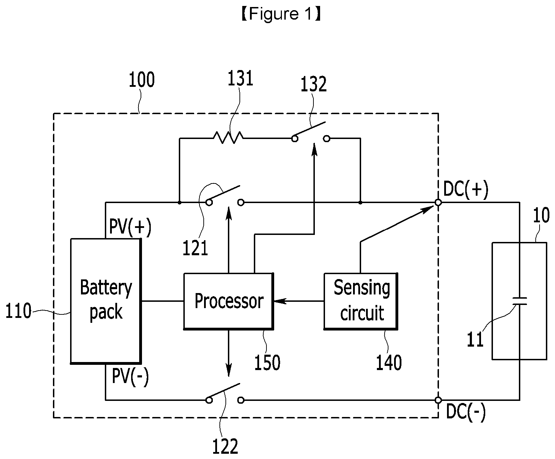

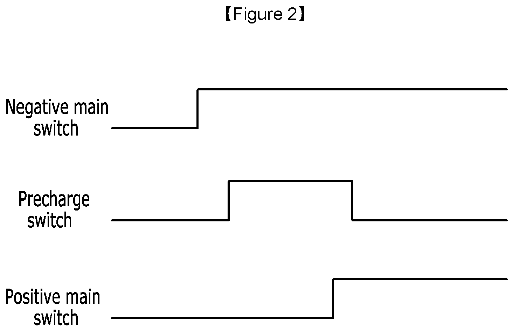

FIG. 1 is a drawing illustrating an example of a battery device according to an embodiment, and FIG. 2 is a drawing illustrating an example of switching timings in the battery device according to the embodiment.

Referring to FIG. 1, a battery device 100 has such a structure that it can be electrically connected to an external device 10 through a positive connection terminal DC(+) and a negative connection terminal DC(-). In the case where the external device is a load, the battery device 100 operates as a power source for supplying power to the load, thereby being discharged. The external device 10 operating as a load may be, for example, an electronic apparatus, a transportation means, or an energy storage system (ESS), and the transportation means may be, for example, an electric vehicle, a hybrid vehicle, or smart mobility.

The battery device 100 includes a battery pack 110, a switch circuit, a precharge circuit, a sensing circuit 140, and a processor 150.

The battery pack 110 includes a plurality of battery cells (not shown in the drawings), and has a positive terminal PV(+) and a negative terminal PV(-). In some embodiments, the battery cells may be secondary batteries which are rechargeable. In an embodiment, in the battery pack 110, a predetermined number of battery cells may be connected in series to constitute a battery module, and supply desired power. In another embodiment, in the battery pack 110, a predetermined number of battery modules may be connected in series or in parallel, and supply desired power.

The switch circuit includes a positive main switch 121 connected between the positive terminal PV(+) of the battery pack 110 and the positive connection terminal DC(+) of the battery device 100, and a negative main switch 122 connected between the negative terminal PV(-) of the battery pack 110 and the negative connection terminal DC(-) of the battery device 100. In an embodiment, each of the switches 121 and 122 may be a contactor composed of a relay. In another embodiment, each of the switches 121 and 122 may be an electric switch such as a transistor. In some embodiments, the switch circuit may further include driver circuits (not shown in the drawings) which control the switches 121 and 122, respectively.

The precharge circuit is connected between the positive terminal PV(+) of the battery pack 110 and the positive connection terminal DC(+) of the battery device 100, and can first charge a capacitor 11 of the external device 10 which is connected to the connection terminals DC(+) and DC(-) during a precharge duration. In some embodiments, the precharge circuit may include a precharge resistor 131 and a precharge switch 132. In the case where the precharge switch 132 is closed, the precharge resistor 131 can be connected between the positive terminal PV(+) of the battery pack 110 and the positive connection terminal DC(+) of the battery device 100. Accordingly, the precharge circuit can first charge the capacitor 11 of the external device 10 through the precharge resistor 131. In some embodiments, the precharge resistor 131 and the precharge switch 132 may be connected in series between the positive terminal PV(+) of the battery pack 110 and the positive connection terminal DC(+) of the battery device 100. In an embodiment, the precharge switch 132 may be a contactor composed of a relay. In another embodiment, the precharge switch 132 may be an electric switch such as a transistor. In some embodiments, the precharge circuit may further include a driver circuit (not shown in the drawings) which controls the precharge switch 132.

The sensing circuit 140 senses the voltage on a predetermined point in the battery device 100. In some embodiments, the sensing circuit 140 may sense the voltage of the positive connection terminal DC(+) of the battery device 100. In some embodiments, the sensing circuit 140 may include a plurality of resistors (not shown in the drawings) connected in series between the positive connection terminal DC(+) and a ground terminal. In this case, the sensing circuit 140 may sense a voltage obtained by dividing the voltage of the positive connection terminal DC(+) by the plurality of resistors, as the voltage of the positive connection terminal DC(+). In some embodiments, the sensing circuit 140 may further include an analog-to-digital converter which converts the voltage obtained by the voltage division using the plurality of resistors into a digital signal, and transmits the digital signal to the processor 150.

The processor 150 may control the operations of the switches 121, 122, and 132. Also, the processor 150 may diagnose a precharge operation on the basis of the voltage sensed by the sensing circuit 140. In some embodiments, the processor 150 may diagnose the capacitance of the capacitor 11 on the basis of the voltage sensed by the sensing circuit 140. In some embodiments, the processor 150 may be, for example, a micro controller unit (MCU).

In some embodiments, the sensing circuit 140 and the processor 150 may be included in a battery management system (BMS) of the battery device.

Referring to FIG. 2, during initial driving of the battery device, the processor 150 first closes the negative main switch 122. Next, the processor 150 closes the precharge switch 132 in the state where the negative main switch 122 is closed. Accordingly, precharge current can be supplied from the battery pack 110 to the capacitor 11 of the external device 10 through the precharge resistor 131, whereby the capacitor 11 can be charged. The duration when the precharge switch 132 is closed, whereby the capacitor 11 is charged may be referred to as a precharge duration.

Next, after charging the capacitor 11 of the external device 10, the processor 150 closes the positive main switch 121 in order to transmit the voltage of the battery pack 110 to the external device 10. In this case, since precharge has been completed, the processor 150 can open the precharge switch 132. Therefore, it is possible to prevent rush current from occurring when the voltage of the battery pack 110 is supplied to the external device 10 by the voltage to which the capacitor 11 of the external device 10 has been charged. Closing a switch may be referred to as turning on the switch, and opening a switch may be referred to as turning off the switch.

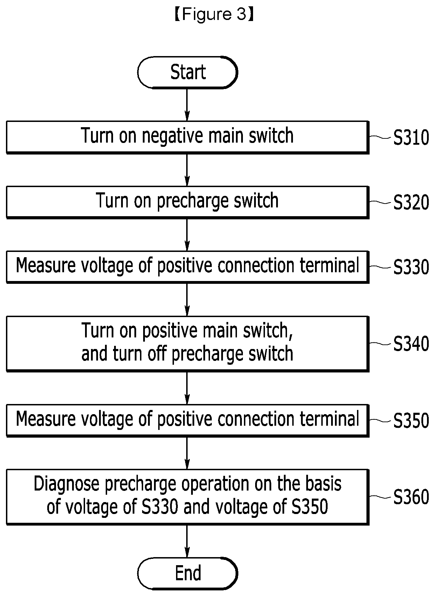

Now, precharge operation diagnosis methods according to various embodiments will be described with reference to FIG. 3 to FIG. 6.

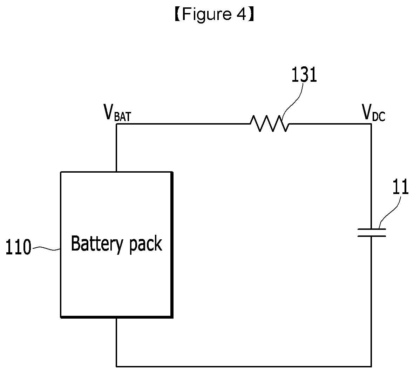

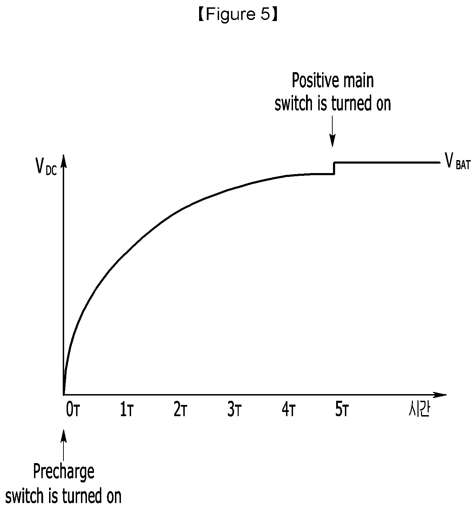

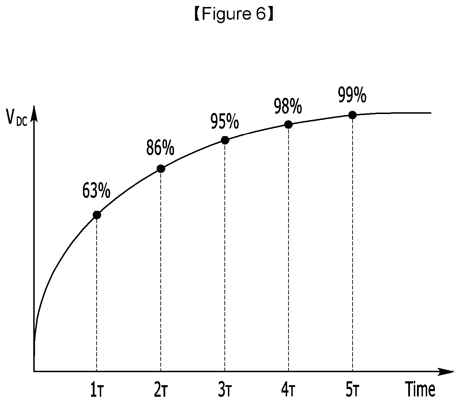

FIG. 3 is a flow chart illustrating an example of a diagnosis method of a battery device according to an embodiment, and FIG. 4 is a drawing illustrating an example of an equivalent circuit of a battery device according to an embodiment during a precharge duration. FIG. 5 is a drawing illustrating an example of the voltage of a positive connection terminal in a battery device according to an embodiment, and FIG. 6 is a drawing illustrating voltage ratios depending on multiples of a time constant.

Referring to FIG. 3, the processor (for example, reference numeral 150 in FIG. 1) of the battery device closes the negative main switch (for example, reference numeral 122 in FIG. 1) (S310), and closes the precharge switch (for example, reference numeral 132 in FIG. 1) (S320). Accordingly, a precharge duration starts, and the capacitor (for example, reference numeral 11 in FIG. 1) of the external device can be charged.

After performing the precharge operation (for example, when the precharge duration ends), the processor 150 closes the positive main switch (for example, reference numeral 121 in FIG. 1) (S340). The processor 150 may apply the voltage of the battery pack 110 to the positive connection terminal DC(+) by closing the positive main switch 121. Immediately before closing the positive main switch 121 (for example, immediately before applying the voltage of the battery pack 110 to the positive connection terminal DC(+)), the processor 150 measures the voltage of the positive connection terminal (for example, reference symbol DC(+)) of the battery device sensed by the sensing circuit (for example, reference numeral 140 in FIG. 1) (S330). Also, immediately after closing the positive main switch 121 (for example, immediately after applying the voltage of the battery pack 110 to the positive connection terminal DC(+)), the processor 150 measures the voltage of the positive connection terminal (DC(+)) of the battery device sensed by the sensing circuit 140 (S350). In some embodiments, after closing the positive main switch 121, the processor 150 may open the precharge switch 132 (S340).

The processor 150 diagnoses a precharge operation on the basis of the voltage of the positive connection terminal (DC(+)) of the battery device measured immediately before it closed the positive main switch 121 and the voltage of the positive connection terminal (DC(+)) of the battery device measured immediately after it closed the positive main switch 121 (S360).

In some embodiments, in the case of diagnosing that a precharge operation is abnormal, the processor 150 may transmit a warning to the external device.

As shown in FIG. 4, when the precharge switch 132 is closed, an RC equivalent circuit may be formed by the battery pack 110, the precharge resistor 131, and the capacitor 11. Then, the voltage of the capacitor 11, that is, the voltage $V_{DC}$ of the positive connection terminal DC(+) increases on the basis of the time constant $\tau$ of an RC equivalent circuit, as shown in FIG. 5. In this case, the voltage $V_{DC}$ of the capacitor 11 may vary, for example, as Equation 1.

## (Equation 1)

$$V_{DC} = V_{BAT}(1 - e^{-t/\tau})$$

In Equation 1, the time constant $\tau$ is defined as the product of the resistance value $R_P$ of the precharge resistor 131 and the capacitance $C_{EX}$ of the capacitor 11.

The processor 150 may set n times the time constant as a precharge duration (wherein n is a positive real number). For example, the processor 150 may set 5 times the time constant as the precharge duration. In this case, the processor 150 may theoretically calculate the voltage $V_{DC}$ of the positive connection terminal DC(+) when the precharge duration corresponding to n times the time constant elapses. As the voltage $V_{DC}$ of the positive connection terminal DC(+) theoretically calculated, a predetermined ratio to the voltage $V_{BAT}$ of the battery pack 110 may be given. As shown in FIG. 6, the voltage $V_{DC}$ of the positive connection terminal DC(+) at 1 times the time constant ($\tau$) corresponds to 63% of the voltage $V_{BAT}$ of the battery pack 110, and the voltage $V_{DC}$ of the positive connection terminal DC(+) at 2 times the time constant ($2\tau$) corresponds to 86% of the voltage $V_{BAT}$ of the battery pack 110, and the voltage $V_{DC}$ of the positive connection terminal DC(+) at 3 times the time constant ($3\tau$) corresponds to 95% of the voltage $V_{BAT}$ of the battery pack 110, and the voltage $V_{DC}$ of the positive connection terminal DC(+) at 4 times the time constant ($4\tau$) corresponds to 98% of the voltage $V_{BAT}$ of the battery pack 110, and the voltage $V_{DC}$ of the positive connection terminal DC(+) at 5 times the time constant ($5\tau$) corresponds to 99% of the voltage $V_{BAT}$ of the battery pack 110.

Meanwhile, shown in FIG. 5, immediately after the positive main switch 121 is closed, the voltage of the positive connection terminal DC(+) is changed to the voltage $V_{BAT}$ of the battery pack 110. The voltage of the positive connection terminal DC(+) measured immediately after the positive main switch 121 was closed corresponds to the voltage $V_{BAT}$ of the battery pack 110. Therefore, the processor 150 may diagnose the precharge operation by comparing the voltage $V_{DC}$ of the positive connection terminal DC(+) measured immediately before the positive main switch 121 was closed (the voltage of the capacitor 11 measured when the precharge duration ended), and the voltage $V_{BAT}$ of the positive connection terminal DC(+) (the voltage of the battery pack 110) measured immediately after the positive main switch 121 was closed. Further, the processor 150 may estimate the time constant on the basis of the voltage $V_{DC}$ of the positive connection terminal DC(+) measured immediately before the positive main switch 121 was closed, and the voltage $V_{BAT}$ of the positive connection terminal DC(+) measured immediately after the positive main switch 121 was closed. For example, the time constant $\tau$ can be calculated from Equation 1 by setting the voltage of the positive connection terminal DC(+) measured immediately before the positive main switch 121 was closed, the voltage of the positive connection terminal DC(+) measured immediately after the positive main switch 121 was closed, and the time of the precharge duration of the current cycle as $V_{DC}$, $V_{BAT}$, and t, respectively.

In some embodiments, the processor 150 may diagnose the precharge operation by comparing the ratio of the voltage $V_{BAT}$ of the positive connection terminal DC(+) measured immediately after the positive main switch 121 was closed to the voltage $V_{DC}$ of the positive connection terminal DC(+) measured immediately before the positive main switch 121 was closed, with the ratio corresponding to a predetermined multiple of the time constant actually set as the precharge duration (hereinafter, referred to as "criterion ratio"). In an embodiment, in the case where the ratio calculated on the basis of the voltage of the positive connection terminal DC(+) is included in an error range of the criterion ratio, the processor 150 may diagnose that the precharge operation is normal. In the case where the ratio calculated on the basis of the voltage of the positive connection terminal DC(+) is out of the error range of the criterion ratio, the processor 150 may diagnose that the precharge operation is abnormal. In other words, the processor 150 may diagnose that since the difference between the voltage of the capacitor 11 immediately before the positive main switch 121 was closed and the voltage of the battery pack 110 is large, damage to the positive main switch 121 may occur.

In some embodiments, the processor 150 may calculate how many times the time constant the precharge duration is, on the basis of the ratio of the voltage $V_{BAT}$ of the positive connection terminal DC(+) measured immediately after the positive main switch 121 was closed to the voltage $V_{DC}$ of the positive connection terminal DC(+) measured immediately before the positive main switch 121 was closed. The set precharge duration may be n times the time constant, and the calculated precharge duration may be m times the time constant (wherein m is a positive real number). In this case, when m is within an error range of n, the processor 150 may diagnose that the precharge operation is normal. On the other hand, in the case where m is out of the error range of n, the processor 150 may diagnose that the precharge operation is abnormal.

In some embodiments, the processor 150 may estimate the capacitance of the capacitor 11 on the basis of the ratio of the voltage $V_{BAT}$ of the positive connection terminal DC(+) measured immediately after the positive main switch 121 was closed to the voltage $V_{DC}$ of the positive connection terminal DC(+) measured immediately before the positive main switch 121 was closed. The processor 150 may calculate how many times the time constant the precharge duration is, on the basis of the ratio of the voltage $V_{BAT}$ of the positive connection terminal DC(+) measured immediately after the positive main switch 121 was closed to the voltage $V_{DC}$ of the positive connection terminal DC(+) measured immediately before the positive main switch 121 was closed. In the case where the calculated precharge duration is m times the time constant, the processor 150 may calculate the time constant by dividing the precharge duration ($T_P$) by m ($T_P/m$), and estimate the capacitance of the capacitor 11 ($T_P/(m*R_P)$) by dividing the time constant by the resistance ($R_P$) of the precharge resistor 131. In the case where the estimated capacitance is within an error range of the actual capacitance of the capacitor 11, the processor 150 may diagnose that the precharge operation is normal. On the other hand, in the case where the estimated capacitance is out of the error range of the actual capacitance, the processor 150 may diagnose that the precharge operation is abnormal.

In some embodiments, the error range may be determined by experiments.

For example, it is assumed that the precharge duration is set to 5 times the time constant, and the voltage of the battery pack 110 is 400 V, and the resistance value of the precharge resistor 131 is 40 $\Omega$, and the actual capacitance of the capacitor 11 is 1700 $\mu$F. In this case, the time constant is set to 68 ms (= 40 $\Omega$ * 1700 $\mu$F), and the precharge duration is set to 340 ms (= 5 * 68 ms).

In the case where the voltage of the positive connection terminal DC(+) immediately before closing the positive main switch 121 is 396 V, the ratio of the voltage of the positive connection terminal DC(+) immediately after closing the positive main switch 121 to the voltage of the positive connection terminal DC(+) immediately before closing the positive main switch 121 is 99%. Since the calculated ratio is equal to the ratio at 5 times the time constant, the processor 150 may diagnose that the precharge operation is normal.

On the other hand, in the case where the voltage of the positive connection terminal DC(+) immediately before closing the positive main switch 121 is 380 V, the ratio of the voltage of the positive connection terminal DC(+) immediately after closing the positive main switch 121 to the voltage of the positive connection terminal DC(+) immediately before closing the positive main switch 121 is 95%. In this case, as the precharge duration, 3 times the time constant may be calculated. Further, as the capacitance of the capacitor 11, 2833 $\mu$F (= 340 ms/(3 * 40 $\Omega$)) may be estimated. Therefore, the calculated ratio (95%) is 4% lower than the actual ratio (99%), or the calculated multiple of the time constant (3 times the time constant) corresponds to 60% of the actual multiple of the time constant (5 times the time constant), or the estimated capacitance corresponds to 167% of the actual capacitance. So, the processor 150 may diagnose that the precharge duration is abnormal.

According to the embodiments described above, the battery device can diagnose whether the precharge operation is normal, by measuring the voltage of the positive connection terminal DC(+). Further, since the voltage of the positive connection terminal DC(+) is measured immediately before the positive main switch 121 is closed and immediately after the positive main switch 121 is closed, it is possible to minimize the difference between the two voltage measurement time points. In other words, since the two voltage measurements are performed in substantially the same environment, it is possible to minimize errors in elements related to voltage measurement, thereby accurately estimating the time constant or the capacitance.

While this invention has been described in connection with what is presently considered to be practical embodiments, it is to be understood that the invention is not limited to the disclosed embodiments. On the contrary, it is intended to cover various modifications and equivalent arrangements. However, the scope of the invention is solely defined by the appended claims.

**Claims**

1. A battery device (100) having a positive connection terminal (DC+) and a negative connection terminal (DC-) configured to be connected to an external device, comprising:

   a battery pack (110);
   a positive main switch (121) that is connected between the positive terminal of the battery pack and the positive connection terminal;
   a precharge switch (132) that is connected between the positive terminal of the battery pack and the positive connection terminal, and is configured to control a precharge operation of a capacitor of the external device; and
   a processor (150),
   wherein the processor is configured to perform the following:

   performing precharge by closing the precharge switch during a precharge duration;
   closing the positive main switch after the precharge duration; and
   diagnosing the precharge operation, said diagnosing comprising comparing a first voltage of the positive connection terminal immediately before closing the positive main switch with a second voltage of the positive connection terminal immediately after closing the positive main switch.

2. The battery device of claim 1, further comprising:
   a precharge resistor (131) that is connected between the positive terminal and the positive connection terminal when the precharge switch is closed.

3. The battery device of claim 2, wherein:
   the precharge switch and the precharge resistor are connected in series.

4. The battery device of claim 2, wherein:
   the processor is configured to perform the following:

   calculating the ratio of the second voltage to the first voltage; and
   diagnosing the precharge operation by comparing the ratio of the second voltage to the first voltage with a criterion ratio.

5. The battery device of claim 4, the device being configured such that:

   the precharge duration is set to a multiple of a time constant defined by the resistance value of the precharge resistor and the capacitance of the capacitor, and
   the criterion ratio is a ratio defined by the multiple of the time constant.

6. The battery device of claim 4, wherein the processor is configured such that:
   when the ratio of the second voltage to the first voltage is included in an error range of the criterion ratio, the processor diagnoses that the precharge operation is normal.

7. The battery device of claim 4, the device being configured such that:

   the precharge duration is set to 1 times the time constant defined by the resistance value of the precharge resistor and the capacitance of the capacitor, and
   the processor is configured to perform the following:

   calculating the ratio of the second voltage to the first voltage;
   determining 2 times the time constant corresponding to the ratio of the second voltage to the first voltage; and
   diagnosing the precharge operation by comparing 1 times the time constant and 2 times the time constant.

8. The battery device of claim 7, wherein the processor is configured such that:
   when 2 times the time constant is included in an error range of 1 times the time constant, the processor diagnoses that the precharge operation is normal.

9. The battery device of claim 4, the device being configured such that:

a time constant is defined by the resistance value of the precharge resistor and the capacitance of the capacitor, and the processor is configured to perform the following:

calculating the ratio of the second voltage to the first voltage; determining a multiple of the time constant corresponding to the ratio of the second voltage to the first voltage; estimating the capacitance of the capacitor on the basis of the multiple of the time constant, the precharge duration, and the resistance value of the precharge resistor; and diagnosing the precharge operation by comparing the estimated capacitance and the actual capacitance of the capacitor.

10. The battery device of claim 9, wherein the processor is configured such that: when the estimated capacitance is within an error range of the actual capacitance, the processor diagnoses that the precharge operation is normal.

11. A diagnosis method of a battery device including a battery pack, and a positive connection terminal and a negative connection terminal to be connected to an external device, comprising:

a step of performing a precharge operation of precharging a capacitor connected to the positive connection terminal and the negative connection terminal through a precharge resistor; a step of applying the voltage of the battery pack to the positive connection terminal after performing the precharge operation; a step of measuring the voltage of the positive connection terminal as a first voltage immediately before applying the voltage of the battery pack; a step of measuring the voltage of the positive connection terminal as a second voltage immediately after applying the voltage of the battery pack; and a step of diagnosing the precharge operation, said step of diagnosing comprising comparing the first voltage with the second voltage.

12. The diagnosis method of claim 11, wherein: the step of diagnosing the precharge operation includes:

a step of calculating the ratio of the second voltage to the first voltage; and a step of diagnosing the precharge operation by comparing the ratio of the second voltage to the first voltage with a criterion ratio.

13. The diagnosis method of claim 11, wherein:

the precharge duration is set to 1 times the time constant defined by the resistance value of the precharge resistor and the capacitance of the capacitor, and the step of diagnosing the precharge operation includes:

a step of calculating the ratio of the second voltage to the first voltage; a step of determining 2 times the time constant corresponding to the ratio of the second voltage to the first voltage; and a step of diagnosing the precharge operation by comparing 1 times the time constant and 2 times the time constant.

14. The diagnosis method of claim 11, wherein:

a time constant is defined by the resistance value of the precharge resistor and the capacitance of the capacitor, and the step of diagnosing the precharge operation includes:

a step of calculating the ratio of the second voltage to the first voltage; a step of determining a multiple of the time constant corresponding to the ratio of the second voltage to the first voltage; a step of estimating the capacitance of the capacitor on the basis of the multiple of the time constant, the precharge duration, and the resistance value of the precharge resistor; and a step of diagnosing the precharge operation by comparing the estimated capacitance and the actual capacitance of the capacitor.

15. A battery management system of a battery device according to any one of claims 1 to 10, said battery device having a positive connection terminal (DC+) and a negative connection terminal (DC-) configured to be connected to an external device, said battery device comprising a battery pack (110) ; said battery management system comprising:

a positive main switch (121) that is configured to be connected between the positive terminal of the battery pack and the positive connection terminal;

a precharge switch (132) that is configured to be connected between the positive terminal of the battery pack and the positive connection terminal, and is configured to control a precharge operation of a capacitor of the external device; and

a processor (150),

wherein the processor is configured to perform the following:

performing precharge by closing the precharge switch during a precharge duration; closing the positive main switch after the precharge duration; and diagnosing the precharge operation, said diagnosing comprising comparing a first voltage of the positive connection terminal immediately before closing the positive main switch with a second voltage of the positive connection terminal immediately after closing the positive main switch.

## Patentansprüche

1.  Batterievorrichtung (100) mit einem positiven Verbindungsanschluss (DC+) und einem negativen Verbindungsanschluss (DC-), welche dazu eingerichtet sind, mit einer externen Vorrichtung verbunden zu sein, umfassend:

    einen Batteriepack (110);
    einen positiven Hauptschalter (121), welcher zwischen den positiven Anschluss des Batteriepacks und den positiven Verbindungsanschluss geschaltet ist;
    einen Vorladeschalter (132), welcher zwischen den positiven Anschluss des Batteriepacks und den positiven Verbindungsanschluss geschaltet ist und dazu eingerichtet ist, einen Vorladevorgang eines Kondensators der externen Vorrichtung zu steuern; und
    einen Prozessor (150),
    wobei der Prozessor dazu eingerichtet ist, das Folgende durchzuführen:

    Durchführen eines Vorladens durch Schließen des Vorladeschalters während einer Vorladedauer;
    Schließen des positiven Hauptschalters nach der Vorladedauer; und
    Diagnostizieren des Vorladevorgangs, wobei das Diagnostizieren ein Vergleichen einer ersten Spannung des positiven Verbindungsanschlusses unmittelbar vor einem Schließen des positiven Hauptschalters mit einer zweiten Spannung des positiven Verbindungsanschlusses unmittelbar nach einem Schließen des positiven Hauptschalters umfasst.

2.  Batterievorrichtung nach Anspruch 1, ferner umfassend:
    einen Vorladewiderstand (131), welcher zwischen den positiven Anschluss und den positiven Verbindungsanschluss geschaltet ist, wenn der Vorladeschalter geschlossen ist.

3.  Batterievorrichtung nach Anspruch 2, wobei:
    der Vorladeschalter und der Vorladewiderstand in Reihe geschaltet sind.

4.  Batterievorrichtung nach Anspruch 2, wobei:
    der Prozessor dazu eingerichtet ist, das Folgende durchzuführen:

    Berechnen des Verhältnisses der zweiten Spannung zu der ersten Spannung; und
    Diagnostizieren des Vorladevorgangs durch Vergleichen des Verhältnisses der zweiten Spannung zu der ersten Spannung mit einem Kriteriumsverhältnis.

5.  Batterievorrichtung nach Anspruch 4, wobei die Vorrichtung derart eingerichtet ist, dass:

    die Vorladedauer auf ein Vielfaches einer Zeitkonstante eingestellt ist, welche durch den Widerstandswert des Vorladewiderstands und die Kapazität des Kondensators definiert ist; und
    das Kriteriumsverhältnis ein Verhältnis ist, welches durch das Vielfache der Zeitkonstante definiert ist.

6.  Batterievorrichtung nach Anspruch 4, wobei der Prozessor derart eingerichtet ist, dass:
    wenn das Verhältnis der zweiten Spannung zu der ersten Spannung in einem Fehlerbereichs des Kriteriumsverhältnisses umfasst ist, der Prozessor diagnostiziert, dass der Vorladevorgang normal ist.

7.  Batterievorrichtung nach Anspruch 4, wobei die Vorrichtung derart eingerichtet ist, dass:

    die Vorladedauer auf ein 1-faches der Zeitkonstante eingestellt ist, welche durch den Widerstandswert des Vorladewiderstands und die Kapazität des Kondensators definiert ist; und
    der Prozessor dazu eingerichtet ist, das Folgende durchzuführen:

    Berechnen des Verhältnisses der zweiten Spannung zu der ersten Spannung;
    Bestimmen eines 2-fachen der Zeitkonstante entsprechend dem Verhältnis der zweiten Spannung zu der ersten Spannung; und
Diagnostizieren des Vorladevorgangs durch Vergleichen eines 1-fachen der Zeitkonstante mit einem 2-fachen der Zeitkonstante.

8. Batterievorrichtung nach Anspruch 7, wobei der Prozessor derart eingerichtet ist, dass:
wenn ein 2-faches der Zeitkonstante in einem Fehlerbereich eines 1-fachen der Zeitkonstante umfasst ist, der Prozessor diagnostiziert, dass der Vorladevorgang normal ist.

9. Batterievorrichtung nach Anspruch 4, wobei die Vorrichtung derart eingerichtet ist, dass:

eine Zeitkonstante durch den Widerstandswert des Vorladewiderstands und die Kapazität des Kondensators definiert ist; und
der Prozessor dazu eingerichtet ist, das Folgende durchzuführen:

Berechnen des Verhältnisses der zweiten Spannung zu der ersten Spannung;
Bestimmen eines Vielfachen der Zeitkonstante entsprechend dem Verhältnis der zweiten Spannung zu der ersten Spannung;
Schätzen der Kapazität des Kondensators auf der Grundlage des Vielfachen der Zeitkonstante, der Vorladedauer und des Widerstandswerts des Vorladewiderstands; und
Diagnostizieren des Vorladevorgangs durch Vergleichen der geschätzten Kapazität mit der tatsächlichen Kapazität des Kondensators.

10. Batterievorrichtung nach Anspruch 9, wobei der Prozessor derart eingerichtet ist, dass:
wenn die geschätzte Kapazität innerhalb eines Fehlerbereichs der tatsächlichen Kapazität ist, der Prozessor diagnostiziert, dass der Vorladevorgang normal ist.

11. Diagnoseverfahren einer Batterievorrichtung, welche einen Batteriepack und einen positiven Verbindungsanschluss und einen negativen Verbindungsanschluss zum Verbinden mit einer externen Vorrichtung umfasst, umfassend:

einen Schritt eines Durchführens eines Vorladevorgangs zum Vorladen eines Kondensators, welcher durch einen Vorladewiderstand mit dem positiven Verbindungsanschluss und dem negativen Verbindungsanschluss verbunden ist; einen Schritt eines Anlegens der Spannung des Batteriepacks an den positiven Verbindungsanschluss nach Durchführen des Vorladevorgangs;
einen Schritt eines Messens der Spannung des positiven Verbindungsanschlusses als eine erste Spannung unmittelbar vor dem Anlegen der Spannung des Batteriepacks;
einen Schritt eines Messens der Spannung des positiven Verbindungsanschlusses als eine zweite Spannung unmittelbar nach dem Anlegen der Spannung des Batteriepacks; und
einen Schritt eines Diagnostizierens des Vorladevorgangs, wobei der Schritt des Diagnostizierens ein Vergleichen der ersten Spannung mit der zweiten Spannung umfasst.

12. Diagnoseverfahren nach Anspruch 11, wobei:
der Schritt eines Diagnostizierens des Vorladevorgangs umfasst:

einen Schritt eines Berechnens des Verhältnisses der zweiten Spannung zu der ersten Spannung; und
einen Schritt eines Diagnostizierens des Vorladevorgangs durch Vergleichen des Verhältnisses der zweiten Spannung zu der ersten Spannung mit einem Kriteriumsverhältnis.

13. Diagnoseverfahren nach Anspruch 11, wobei:

die Vorladedauer auf ein 1-faches der Zeitkonstante eingestellt ist, welche durch den Widerstandswert des Vorladewiderstands und die Kapazität des Kondensators definiert ist; und
der Schritt eines Diagnostizierens des Vorladevorgangs umfasst:

einen Schritt eines Berechnens des Verhältnisses der zweiten Spannung zu der ersten Spannung;
einen Schritt eines Bestimmens eines 2-fachen der Zeitkonstante entsprechend dem Verhältnis der zweiten Spannung zu der ersten Spannung; und
einen Schritt eines Diagnostizierens des Vorladevorgangs durch Vergleichen eines 1-fachen der Zeitkonstante mit einem 2-fachen der Zeitkonstante.

14. Diagnoseverfahren nach Anspruch 11, wobei:

eine Zeitkonstante durch den Widerstandswert des Vorladewiderstands und die Kapazität des Kondensators definiert ist; und
der Schritt eines Diagnostizierens des Vorladevorgangs umfasst:

einen Schritt eines Berechnens des Verhältnisses der zweiten Spannung zu der ersten Spannung;

einen Schritt eines Bestimmens eines Vielfachen der Zeitkonstante entsprechend dem Verhältnis der zweiten Spannung zu der ersten Spannung;

einen Schritt eines Schätzens der Kapazität des Kondensators auf der Grundlage des Vielfachen der Zeitkonstante, der Vorladedauer und des Widerstandswerts des Vorladewiderstands; und

einen Schritt eines Diagnostizierens des Vorladevorgangs durch Vergleichen der geschätzten Kapazität mit der tatsächlichen Kapazität des Kondensators.

15. Batteriemanagementsystem einer Batterievorrichtung nach einem der Ansprüche 1 bis 10, wobei die Batterievorrichtung einen positiven Verbindungsanschluss (DC+) und einen negativen Verbindungsanschluss (DC-) umfasst, welche dazu eingerichtet sind, mit einer externen Vorrichtung verbunden zu werden, wobei die Batterievorrichtung einen Batteriepack (110) umfasst;

das Batteriemanagementsystem umfassend:

einen positiven Hauptschalter (121), welcher dazu eingerichtet ist, zwischen den positiven Anschluss des Batteriepacks und den positiven Verbindungsanschluss geschaltet zu sein;

einen Vorladeschalter (132), welche dazu eingerichtet ist, zwischen den positiven Anschluss des Batteriepacks und den positiven Verbindungsanschluss geschaltet zu sein und dazu eingerichtet ist, einen Vorladevorgang eines Kondensators der externen Vorrichtung zu steuern; und

einen Prozessor (150),

wobei der Prozessor dazu eingerichtet ist, das Folgende durchzuführen:

Durchführen eines Vorladens durch Schließen des Vorladeschalters während einer Vorladedauer;

Schließen des positiven Hauptschalters nach der Vorladedauer; und Diagnostizieren des Vorladevorgangs, wobei das Diagnostizieren ein Vergleichen einer ersten Spannung des positiven Verbindungsanschlusses unmittelbar vor dem Schließen des positiven Hauptschalters mit einer zweiten Spannung des positiven Verbindungsanschlusses unmittelbar nach dem Schließen des positiven Hauptschalters umfasst.

**Revendications**

1. Dispositif de batterie (100) ayant une borne de connexion positive (DC+) et une borne de connexion négative (DC-) configurées pour être connectées à un dispositif externe, comprenant :

un bloc-batterie (110) ;

un commutateur principal positif (121) qui est connecté entre la borne positive du bloc-batterie et la borne de connexion positive ;

un commutateur de précharge (132) qui est connecté entre la borne positive du bloc-batterie et la borne de connexion positive, et est configuré pour commander une opération de précharge d'un condensateur du dispositif externe ; et

un processeur (150),

dans lequel le processeur est configuré pour réaliser les étapes suivantes :

la réalisation d'une précharge par fermeture du commutateur de précharge pendant une durée de précharge ;

la fermeture du commutateur principal positif après la durée de précharge ; et

le diagnostic de l'opération de précharge, ledit diagnostic comprenant la comparaison d'une première tension de la borne de connexion positive immédiatement avant la fermeture du commutateur principal positif à une deuxième tension de la borne de connexion positive immédiatement après la fermeture du commutateur principal positif.

2. Dispositif de batterie selon la revendication 1, comprenant en outre un résistor de précharge (131) qui est connecté entre la borne positive et la borne de connexion positive lorsque le commutateur de précharge est fermé.

3. Dispositif de batterie selon la revendication 2, dans lequel :

le commutateur de précharge et le résistor de précharge sont connectés en série.

4. Dispositif de batterie selon la revendication 2, dans lequel :

le processeur est configuré pour réaliser les étapes suivantes :

le calcul du rapport entre la deuxième tension et la première tension ; et

le diagnostic de l'opération de précharge en comparant le rapport entre la deuxième tension et la première tension à un rapport de critère.

5. Dispositif de batterie selon la revendication 4, le dispositif étant configuré de sorte que :

la durée de précharge est fixée à un multiple d'une constante de temps définie par la valeur de résistance du résistor de précharge et la capacité du condensateur, et
le rapport de critère est un rapport défini par le multiple de la constante de temps.

6. Dispositif de batterie selon la revendication 4, dans lequel le processeur est configuré de sorte que :
lorsque le rapport entre la deuxième tension et la première tension est inclus dans une plage d'erreur du rapport de critère, le processeur diagnostique que l'opération de précharge est normale.

7. Dispositif de batterie selon la revendication 4, le dispositif étant configuré de sorte que :

la durée de précharge est fixée à 1 fois la constante de temps définie par la valeur de résistance du résistor de précharge et la capacité du condensateur, et
le processeur est configuré pour réaliser les étapes suivantes :

le calcul du rapport entre la deuxième tension et la première tension ;
la détermination de 2 fois la constante de temps correspondant au rapport entre la deuxième tension et la première tension ; et
le diagnostic de l'opération de précharge en comparant 1 fois la constante de temps et 2 fois la constante de temps.

8. Dispositif de batterie selon la revendication 7, dans lequel le processeur est configuré de sorte que :
lorsque 2 fois la constante de temps est inclus dans une plage d'erreur de 1 fois la constante de temps, le processeur diagnostique que l'opération de précharge est normale.

9. Dispositif de batterie selon la revendication 4, le dispositif étant configuré de sorte que :

une constante de temps est définie par la valeur de résistance du résistor de précharge et la capacité du condensateur, et
le processeur est configuré pour réaliser les étapes suivantes :

le calcul du rapport entre la deuxième tension et la première tension ;
la détermination d'un multiple de la constante de temps correspondant au rapport entre la deuxième tension et la première tension ;
l'estimation de la capacité du condensateur sur la base du multiple de la constante de temps, de la durée de précharge et de la valeur de résistance du résistor de précharge ; et
le diagnostic de l'opération de précharge en comparant la capacité estimée et la capacité réelle du condensateur.

10. Dispositif de batterie selon la revendication 9, dans lequel le processeur est configuré de sorte que :
lorsque la capacité estimée se situe dans une plage d'erreur de la capacité réelle, le processeur diagnostique que l'opération de précharge est normale.

11. Procédé de diagnostic d'un dispositif de batterie incluant un bloc-batterie, et une borne de connexion positive et une borne de connexion négative à connecter à un dispositif externe, comprenant :

une étape de réalisation d'une opération de précharge pour précharger un condensateur connecté à la borne de connexion positive et à la borne de connexion négative par l'intermédiaire d'un résistor de précharge ;
une étape d'application de la tension du bloc-batterie à la borne de connexion positive après réalisation de l'opération de précharge ;
une étape de mesure de la tension de la borne de connexion positive en tant que première tension immédiatement avant l'application de la tension du bloc-batterie ;
une étape de mesure de la tension de la borne de connexion positive en tant que deuxième tension immédiatement après l'application de la tension du bloc-batterie ; et
une étape de diagnostic de l'opération de précharge, ladite étape de diagnostic comprenant la comparaison de la première tension à la deuxième tension.

12. Procédé de diagnostic selon la revendication 11, dans lequel :
l'étape de diagnostic de l'opération de précharge inclut :

une étape de calcul du rapport entre la deuxième tension et la première tension ; et
une étape de diagnostic de l'opération de précharge en comparant le rapport entre la deuxième tension et la première tension à un rapport de critère.

13. Procédé de diagnostic selon la revendication 11, dans lequel :

la durée de précharge est fixée à 1 fois la constante de temps définie par la valeur de résistance du résistor de précharge et la capacité du condensateur, et

l'étape de diagnostic de l'opération de précharge inclut :

une étape de calcul du rapport entre la deuxième tension et la première tension ;
une étape de détermination de 2 fois la constante de temps correspondant au rapport entre la deuxième tension et la première tension ; et
une étape de diagnostic de l'opération de précharge en comparant 1 fois la constante de temps et 2 fois la constante de temps.

14. Procédé de diagnostic selon la revendication 11, dans lequel :

une constante de temps est définie par la valeur de résistance du résistor de précharge et la capacité du condensateur, et
l'étape de diagnostic de l'opération de précharge inclut :

une étape de calcul du rapport entre la deuxième tension et la première tension ;
une étape de détermination d'un multiple de la constante de temps correspondant au rapport entre la deuxième tension et la première tension ;
une étape d'estimation de la capacité du condensateur sur la base du multiple de la constante de temps, de la durée de précharge et de la valeur de résistance du résistor de précharge ; et
une étape de diagnostic de l'opération de précharge en comparant la capacité estimée et la capacité réelle du condensateur.

15. Système de gestion de batterie d'un dispositif de batterie selon l'une quelconque des revendications 1 à 10, ledit dispositif de batterie ayant une borne de connexion positive (DC+) et une borne de connexion négative (DC-) configurées pour être connectées à un dispositif externe, ledit dispositif de batterie comprenant un bloc-batterie (110) ;

ledit système de gestion de batterie comprenant :

un commutateur principal positif (121) qui est configuré pour être connecté entre la borne positive du bloc-batterie et la borne de connexion positive ;
un commutateur de précharge (132) qui est configuré pour être connecté entre la borne positive du bloc-batterie et la borne de connexion positive, et est configuré pour commander une opération de précharge d'un condensateur du dispositif externe ; et
un processeur (150),

dans lequel le processeur est configuré pour réaliser les étapes suivantes :

la réalisation d'une précharge par fermeture du commutateur de précharge pendant une durée de précharge ;
la fermeture du commutateur principal positif après la durée de précharge ; et
le diagnostic de l'opération de précharge, ledit diagnostic comprenant la comparaison d'une première tension de la borne de connexion positive immédiatement avant la fermeture du commutateur principal positif à une deuxième tension de la borne de connexion positive immédiatement après la fermeture du commutateur principal positif.

【Figure 1】

【Figure 2】

Negative main
switch

Precharge
switch

Positive main
switch

【Figure 3】

```
        ( Start )
            |
  +---------------------------+
  | Turn on negative main switch |—S310
  +---------------------------+
            |
  +---------------------------+
  |   Turn on precharge switch   |—S320
  +---------------------------+
            |
  +------------------------------------+
  | Measure voltage of positive connection terminal |—S330
  +------------------------------------+
            |
  +---------------------------+
  |   Turn on positive main switch,   |—S340
  |   and turn off precharge switch   |
  +---------------------------+
            |
  +------------------------------------+
  | Measure voltage of positive connection terminal |—S350
  +------------------------------------+
            |
  +---------------------------+
  | Diagnose precharge operation on the basis |—S360
  |  of voltage of S330 and voltage of S350   |
  +---------------------------+
            |
         ( End )
```

【Figure 4】

【Figure 5】

【Figure 6】

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20200144832 A